# EUROPÄISCHE PATENTSCHRIFT

(11) **EP 1 463 397 B1**
(45) Veröffentlichungstag und Bekanntmachung des Hinweises auf die Patenterteilung: **24.06.2009**
(21) Anmeldenummer: 04006638.3
(22) Anmeldetag: 19.03.2004
(51) Int. Cl.: H05K 7/20, G06F 1/20, F04D 29/60

(54) **Halteelement für einen Lüfter nach Art eines Klein- oder Kleinstlüfters**
Holding element for small type fans
Element de fixation pour des petits ventilateurs

(30) Priorität: 25.03.2003 DE 20304718 U
(43) Veröffentlichungstag der Anmeldung: 29.09.2004
(60) Teilanmeldung: 06006209.8
(73) Patentinhaber: ebm-papst St. Georgen GmbH & Co. KG, 78112 St. Georgen (DE)
(72) Erfinder: Winkler, Wolfgang Arno, 78112 St. Georgen (DE)
(74) Vertreter: Raible, Hans

(56) Entgegenhaltungen:
- EP-A- 0 755 177
- EP-A- 0 822 337
- US-A- 5 478 221
- US-B1- 6 183 214

## Beschreibung

Die Erfindung betrifft ein Halteelement für die Halterung eines Lüfters nach Art eines Klein- oder Kleinstlüfters auf einer Leiterplatte.

In der Elektronik wird immer häufiger eine direkte Kühlung einzelner Wärme erzeugender Elemente direkt an oder auf einer Leiterplatte gewünscht. Moderne Klein- und Kleinstlüfter können diese Anforderungen erfüllen, da sie schon mit Außenabmessungen von nur 25 x 25 x 8 mm, 40 x 40 x 10 mm, 40 x 40 x 20 mm oder auch 60 x 60 x 15 mm hergestellt werden, um nur beispielhaft einige typische Abmessungen zu nennen. Solche kleinen Lüfter haben ein Gewicht etwa im Bereich von 5 bis 100 g. Problematisch für ihre Anwendung direkt auf einer Leiterplatte sind einmal die Montage selbst, und zum anderen die hierzu notwendigen Halterungen und Befestigungen.

Bekannte Befestigungen und Halterungen sind aufwändig und kompliziert in ihrem Aufbau oder ihrer Montage, was ihre Anwendung in der Massenfertigung erschwert.

Aus der EP-A-0 822 337 kennt man ein Halteelement zur Befestigung eines elektrischen Lüfters, insbesondere eines Kleinstlüfters, auf einer Leiterplatte. Das Halteelement hat Steckelemente, die jeweils in ein Montageloch des Lüfters einsteckbar sind, um diesen in seiner Lage relativ zum Halteelement zu fixieren. Ferner hat es stiftartige Befestigungselemente, die dazu ausgebildet sind, mit einer Öffnung der Leiterplatte zusammen zu wirken.

Aus der EP-A-0 755 177 kennt man eine Abschirmkappe, die zur lötfreien, geerdeten Befestigung auf einer Leiterplatte dient. Dazu hat die Abschirmkappe einen federnden Erdungsarm, der im montierten Zustand mit Vorspannung gegen einen Erdungsabschnitt auf der Leiterplatte anliegt. Zur lötfreien Befestigung auf der Leiterplatte dienen Haken an der Abschirmkappe. Diese greifen mit ihren verbreiterten Enden durch Löcher der Leiterplatte und sind an dieser eingerastet.

Der Erfindung liegt die Aufgabe zugrunde, ein Halteelement zur Verfügung zu stellen, das einfach in seinem Aufbau und billig herzustellen ist und das eine sichere Befestigung auf einer Leiterplatte ermöglicht.

Eine Lösung der gestellten Aufgabe ergibt sich durch den Gegenstand des Anspruchs 1. Ein solches Halteelement, an dem ein kleiner Lüfter befestigt ist, kann sicher und einfach an einer Leiterplatte befestigt werden. Die verformbaren Arretierungsfortsätze ermöglichen eine spielfreie, automatisierte Befestigung des Halteelements an der Leiterplatte durch einfaches Drehen des Arretierungsfortsatzes. Durch die Schrägflächen wird ein selbsttätiges Heranziehen des Halteelements an die Leiterplatte erreicht. Gleichzeitig ergibt sich hierdurch eine Dickentoleranz gegenüber der Leiterplatte, so dass man eine spielfreie Verbindung erhält.

Eine andere vorteilhafte Ausgestaltung der Erfindung ergibt sich aus dem Gegenstand des Anspruchs 6. Man erreicht so, dass eine einfache, automatisierte Bestückung ermöglicht wird, wobei das Halteelement beim Verdrillen der Arretierungsfortsätze nicht ungewollt verschoben werden kann. Weiterhin wird eine ungewollte Kräftebeaufschlagung auf die Arretierungsfortsätze vermieden.

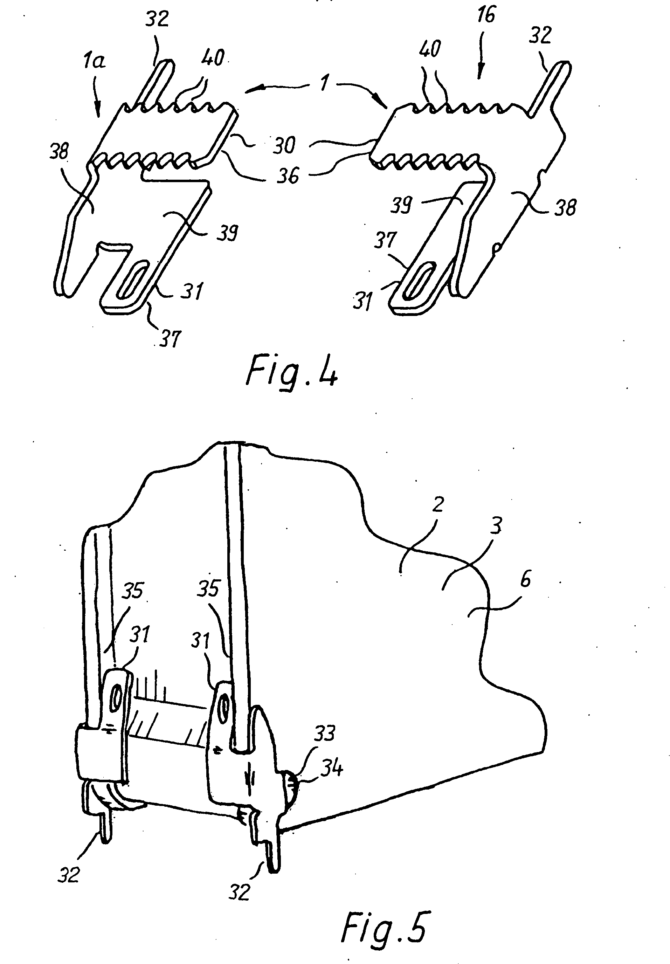

Bei den Fig. 4 bis 6 handelt es sich nicht um einen Teil der Erfindung, sondern um ein Beispiel, das das Verständnis der Erfindung erleichtert.

Weitere Einzelheiten und vorteilhafte Weiterbildungen der Erfindung ergeben sich aus den im folgenden beschriebenen und in der Zeichnung dargestellten, in keiner Weise als Einschränkung der Erfindung zu verstehenden Ausführungsbeispielen, sowie aus den anderen Unteransprüchen. Es zeigt:
- Fig. 1: eine erste Ausführungsform, eines erfindungsgemäßen Halteelements,
- Fig. 2: das Halteelement aus Fig. 1 am Bauelement,
- Fig. 3: Das Halteelement aus Fig. 1 und 2, arretiert an einer Leiterplatte,
- Fig. 4: ein Halteelement, das nicht einen Teil der Erfindung sondern ein Beispiel ist, in rechter und linker Ausführung,
- Fig. 5: die Halteelemente aus Fig. 4 am Bauelement, und
- Fig. 6: ein Halteelement aus Fig. 5 aus einem anderen Winkel betrachtet.

Die in den Figuren gleichen Bezugsziffern bezeichnen gleiche oder gleich wirkende Elemente.

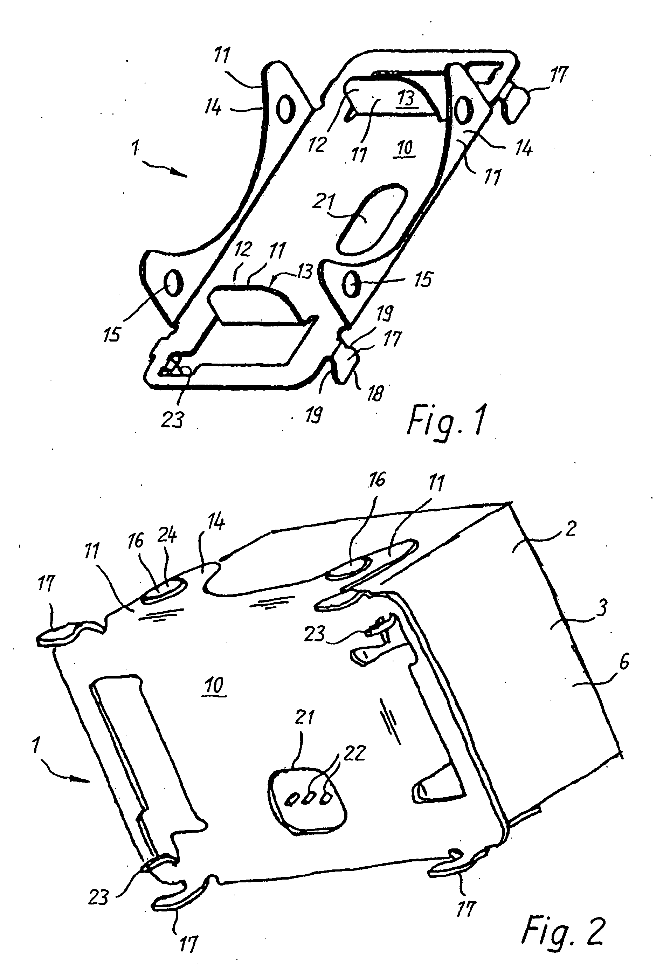

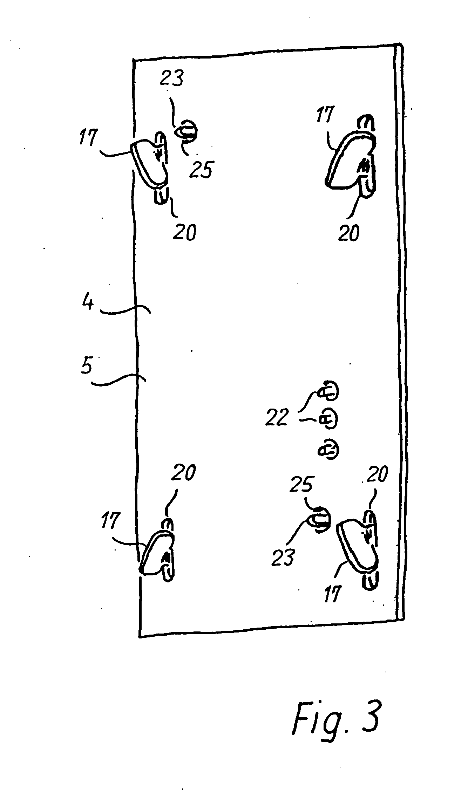

**Fig. 1** zeigt ein erfindungsgemäßes Halteelement 1 zur Befestigung eines Bauelements 2, **Fig. 2** zeigt das Halteelement 1 an einem Bauelement 2, und **Fig. 3** zeigt das Halteelement 1 an einer Leiterplatte 5 arretiert.

Das Halteelement 1 weist eine Halteelementgrundplatte 10, Halterungsausformungen 11 und Arretierungsfortsätze 17 auf.

Die Halterungsausformungen 11 dienen zur Halterung des Bauelements 2 und zur Fixierung des Bauelements 2 in seiner Lage zum Halteelement 1 (siehe hierzu auch Fig. 2). Die Halterungsausformungen 11, die dem Bauelement 2 Abstützflächen 13 bieten, sind durch Anschlaglaschen 12 und Befestigungslaschen 14 gebildet. Das Bauelement 2 kann mit den Halterungsausformungen 11 verklebt oder verschweißt werden, oder wie im gezeigten Beispiel (Fig. 2) mittels in den Befestigungslaschen 14 gestanzter Öffnungen 15, welche sich mit entsprechenden Öffnungen am Bauelement 2 überdecken, und mit einer durch die Öffnungen durchgreifenden Rohrniete 24 als Befestigungsmittel 16 verbunden werden. Die Befestigungslaschen 14 können zur mechanischen Verbindung auch Rastnasen oder ähnliches aufweisen, welche mit entsprechenden Kanten oder Vorsprüngen am Bauelement verrasten können.

Die vier Arretierungsfortsätze 17 dienen zur Befestigung des Halteelements 1 an einem Träger 4, im Beispiel an einer Leiterplatte 5 (vgl. Fig. 3).

Die Arretierungsfortsätze 17 wirken mit einer Aufnahme-Öffnung 20 so zusammen, dass eine dauerhafte Verbindung durch Formschluss entsteht, wenn die Arretierungsfortsätze in den im Wesentlichen schlitzförmigen Aufnahme-Öffnungen 20 der Leiterplatte 5 verformt werden.

Hierzu ist ein Arretierungsfortsatz 17 flach als Lasche ausgebildet und weist zu seinem vom Halteelement 1 wegragenden Ende 18 hin zwei breiter werdende Schrägflächen 19 auf (siehe Fig. 1). Durch diese Form wird auch ein Toleranzausgleich bezüglich der Dicke der Leiterplatte erreicht, da es immer zu einer spielfreien Verbindung zwischen Halteelement und Leiterplatte kommt.

Damit eine elektrische Kontaktierung zwischen an dem Bauelement 2 und an der Leiterplatte 5 ausgebildeten Stromzuführungen oder Leitungen erfolgen kann, weist das Halteelement 1 einen Kontaktierungs-Durchgriff 21 auf, durch welchen Kontaktierungsfortsätze 22 in Form von Drahtstiften, von dem Bauelement 2 zur Leiterplatte 5 durchreichen (siehe Fig. 2 und Fig. 3).

Das Halteelement 1 weist weiterhin zwei Lagefixierungsfortsätze 23 auf, welche in in der Leiterplatte 5 ausgebildete Aufnahmeöffnungen 25 eingreifen. Dies bewirkt, dass das Halteelement 1 in zwei von drei Raumrichtungen in seiner Lage relativ zur Leiterplatte 5 gehalten wird. Hierdurch werden auch mechanische Kräfte vom Bauelement bzw. vom Halteelement 1 auf die Leiterplatte 5 übertragen. Eine automatische Bestückung ist ermöglicht und vereinfacht durch die Selbstjustierung zur Leiterplatte.

Durch die Ausgestaltung des Halteelements 1 ist es möglich, dieses einstückig aus Blech herzustellen, wobei die Halterungsausformung 11 und/oder der Arretierungsfortsatz 17 und/oder der Lagefixierungsfortsatz 23 insbesondere durch Ausstanzen und Abkröpfen aus einem Blech hergestellt wird.

Ein solches Halteelement 1 eignet sich insbesondere auch für schwere Bauelemente 2, da die Halteelementgrundplatte 10 für die Aufnahme des Bauelements 2 eine stabile Basis bildet.

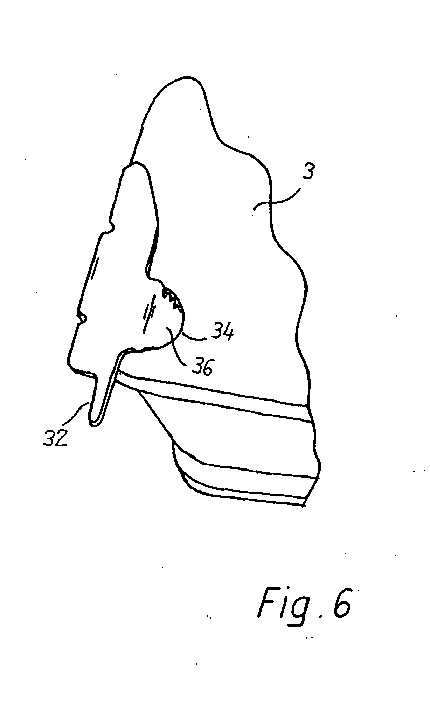

**Fig. 4** zeigt eine weitere Ausgestaltung eines Halteelements 1, 1a, 1b zur Befestigung eines Bauelements, **Fig. 5** zeigt das Halteelement 1, 1a, 1b an einem Bauelement 2, und **Fig. 6** zeigt das Halteelement 1, 1a, 1b aus einem anderen Winkel betrachtet.

Gezeigt ist eine rechte 1a und eine linke 1b Ausführungsform, zur Anbringung an zwei gegenüberliegenden Seiten eines Bauelements 2 (siehe hierzu auch Fig. 5).

Das Halteelement 1, 1a, 1b weist einen Einsteckfortsatz 30 auf, welcher zur Einführung in eine Öffnung 33 vorgesehen ist, welche Öffnung 33 im Beispiel durch eine Durchführung 34 im Lüfter 3 ausgebildet ist. Der Einsteckfortsatz 30 ist als ein viele Widerhaken 40 aufweisender Einpresssteg 36 (auch Krallensteg genannt) ausgebildet. Dieser wird mit Kraftaufwand in die Öffnung 33 (Durchführung 34) am Lüfter 3 eingedrückt und bildet eine feste Verbindung zwischen Lüfter und Halteelement (siehe auch Fig. 6).

Das Halteelement 1 verfügt weiterhin über einen formstabil verformbaren Sperrfortsatz 31, der durch eine Lötlasche 37 gebildet ist, welcher eine elektrische Kontaktierung durch Löten oder durch einen Crimpanschluss ermöglicht.

Der Sperrfortsatz 31 (Lötlasche 37) ist so ausgestaltet, dass er zusammen mit dem Einsteckfortsatz 30 in der Öffnung 33 (Durchführung 34) des Bauelements 2 (Lüfter 3) eine formschlüssige Verbindung des Halteelements 1 mit dem Lüfter 3 bewirkt.

Hierzu wird der Sperrfortsatz 31 in seiner sperrenden Endposition am Lüfter 3 zu seiner Anlagefläche 39, von welcher er weg verläuft, leicht abgebogen (siehe Fig. 5). Der Einsteckfortsatz 30 kann nun nicht mehr aus der Öffnung 33 im Lüfter 3 gezogen werden, da der Sperrfortsatz 31 den Vorsprung 35 des Lüfters 3 hintergreift und das Herausziehen des Einsteckfortsatzes 30 aus der Öffnung 33 hemmt. Durch die doppelte Sicherung durch Sperrfortsatz 31 und Widerhaken 40 ist eine ungewollte Lösung des Halteelements 1a, 1b vom Lüfter 3 ausgeschlossen.

Zur Befestigung des Halteelements 1a, 1b an einem Träger, beispielsweise einer Leiterplatte, weist das Halteelement einen Befestigungsfortsatz 32 auf, welcher mit der Leiterplatte verlötet wird. Die Verbindung mit einer Leiterplatte oder dergleichen kann auch durch Verformung des Befestigungsfortsatzes 32 in einer Öffnung der Leiterplatte erfolgen.

Das Halteelement 1, 1a, 1b besteht bevorzugt ganz aus Metall und dient so über die Lötlasche 37 und den Befestigungsfortsatz 32 zur elektrischen Verbindung des Lüfters 3 mit Leitungen auf einer Leiterplatte. Hierdurch werden sonst notwendige zusätzliche Kontakte und Befestigungsund Kontaktierungsschritte eingespart.

Das Halteelement 1 ist einstückig aus Blech ausgebildet, wobei der Einsteckfortsatz 30, der Sperrfortsatz 31 und der Befestigungsfortsatz 32 durch Ausstanzen und Abkröpfen aus einem Blech hergestellt sind, wodurch der Einsteckfortsatz 30 und die den Sperrfortsatz 31 tragende Anlagefläche (39) rechtwinklig von der Grundfläche 38 des Halteelements 1 weg verlaufen.

Naturgemäß sind im Rahmen der Erfindung vielfache Abwandlungen möglich.

## Patentansprüche

1. Halteelement zur Befestigung eines Lüfters nach Art eines Klein- oder Kleinstlüfters (3) auf einer Leiterplatte (5),
welches Halteelement (1) Halterungsausformungen (11) aufweist, die dazu ausgebildet sind, den Lüfter (3) in seiner Lage relativ zum Halteelement (1) zu fixieren,
und welches Halteelement (1) wenigstens einen Fortsatz (17) aufweist, welcher dazu ausgebildet ist, mit einer Öffnung (20) der Leiterplatte (5) zusammen zu wirken,
**dadurch gekennzeichnet, dass** der Fortsatz als flaches, verdrehbares Teil (17), insbesondere in Form einer Lasche, ausgebildet ist, das sich
in Richtung zu seinem vom Halteelement (1) weg ragenden Ende (18) hin verbreitert, so dass es eine Befestigung des Halteelements an der Leiterplatte (5) durch Verdrehen dieses verdrehbaren Teil (17) relativ zur Leiterplatte (5) ermöglicht.

2. Halteelement nach Anspruch 1, bei welchem eine Befestigungslasche (14) eine Öffnung (15) aufweist, welche im montierten Zustand mit einer entsprechenden Öffnung des Lüfters (3) fluchtet, so dass ein Befestigungsmittel (16) durch beide Öffnungen hindurch greifen kann.

3. Halteelement nach Anspruch 2, bei welchem das Befestigungsmittel (16) als Rohrniete (24), Schraubenbefestigung oder dergleichen ausgebildet ist.

4. Halteelement nach einem der vorhergehenden Ansprüche, bei welchem die Befestigungslaschen (14) Rastnasen zur Verrastung mit entsprechenden Kanten oder Vorsprüngen am Lüfter (3) aufweisen.

5. Halteelement nach einem der vorhergehenden Ansprüche, welches eine Kontaktierungs-Ausnehmung (21) aufweist, durch welche Kontaktelemente (22) vom Lüfter (3) zur Leiterplatte (5) durchragen können.

6. Halteelement nach einem der vorhergehenden Ansprüche, welches wenigstens einen Lagefixierungsfortsatz (23) aufweist, welcher zum Zusammenwirken mit der Leiterplatte (5) dergestalt ausgebildet ist, dass das Halteelement (1) wenigstens in zwei von drei Raumrichtungen in seiner Lage relativ zur Leiterplatte (5) fixiert ist.

7. Halteelement nach einem der vorhergehenden Ansprüche, welches mindestens teilweise aus Blech ausgebildet ist, wobei die Halterungsausformung (11) und/oder der Arretierungsfortsatz (17) und/oder der Lagefixierungsfortsatz (23) insbesondere durch Ausstanzen und Abkröpfen aus diesem Blech hergestellt sind.

8. Halteelement nach einem der vorhergehenden Ansprüche, welches mit einem Klein- oder Kleinstlüfter (3) verbunden ist.

## Claims

1. Holding element for fixing a fan, of the type of a small or very small fan (3), on a printed circuit board (5),
which holding element (1) has mounting formations (11), which are designed to fix the fan (3) in its position relative to the holding element (1),
and which holding element (1) has at least one extension (17), which is designed to work with an opening (20) of the printed circuit board (5),
**characterized in that** the extension is in the form of a flat, rotatable part (17), in particular in the form of a shackle, which widens in the direction of its end (18) projecting away from the holding element (1), so that it makes it possible to fix the holding element on the printed circuit board (5) by rotating this rotatable part (17) relative to the printed circuit board (5).

2. Holding element according to Claim 1, wherein a fixing shackle (14) has an opening (15), which in the mounted state aligns with a corresponding opening of the fan (3), so that a fixing means (16) can grip through both openings.

3. Holding element according to Claim 2, wherein the fixing means (16) are in the form of tubular rivets (24), screw fixing or similar.

4. Holding element according to one of the preceding claims, wherein the fixing shackles (14) have locking lugs for locking with corresponding edges or projections on the fan (3).

5. Holding element according to one of the preceding claims, which has a contacting recess (21), through which contact elements (22) can project from the fan (3) to the printed circuit board (5).

6. Holding element according to one of the preceding claims, which has at least one position fixing extension (23), which is designed to work with the printed circuit board (5) in such a way that the holding element (1) is fixed in its position relative to the printed circuit board (5) in at least two of three spatial directions.

7. Holding element according to one of the preceding claims, which is made at least partly of sheet metal, and wherein the mounting formation (11) and/or the locking extension (17) and/or the position fixing extension (23) are produced from this sheet metal, in particular by stamping out and bending at right angles.

8. Holding element according to one of the preceding claims, which is connected to a small or very small fan (3).

## Revendications

1. Elément de retenue pour fixer un ventilateur à la manière d'un mini- ou microventilateur (3) sur une carte de circuits imprimés (5),
lequel élément de retenue (1) présente des formations de fixation (11) qui sont réalisées pour fixer le ventilateur (3) dans sa position par rapport à l'élément de retenue (1),
et lequel élément de retenue (1) présente au moins un prolongement (17) qui est réalisé pour coopérer avec une ouverture (20) de la carte de circuits imprimés (5),
**caractérisé en ce que** le prolongement est réalisé sous la forme d'une pièce plate tournable (17), en particulier sous la forme d'une patte, qui s'élargit dans la direction de son extrémité (18) en saillie s'éloignant de l'élément de retenue (1), de sorte qu'elle permet une fixation de l'élément de retenue sur la carte de circuits imprimés (5) par rotation de cette pièce tournable (17) par rapport à la carte de circuits imprimés (5).

2. Elément de retenue selon la revendication 1, dans lequel une patte de fixation (14) présente une ouverture (15), laquelle est alignée à l'état monté avec une ouverture correspondante du ventilateur (3), de sorte qu'un moyen de fixation (16) peut passer à travers les deux ouvertures.

3. Elément de retenue selon la revendication 2, dans lequel le moyen de fixation (16) est réalisé sous la forme d'un rivet tubulaire (14), d'une fixation par vis ou analogue.

4. Elément de retenue selon l'une des revendications précédentes, dans lequel les pattes de fixation (14) présentent des ergots pour l'encliquetage avec des arêtes ou des saillies correspondantes sur le ventilateur (3).

5. Elément de retenue selon l'une des revendications précédentes, lequel présente un évidement de contact (21) à travers lequel des éléments de contact (22) du ventilateur (3) peuvent dépasser vers la carte de circuits imprimés (5).

6. Elément de retenue selon l'une des revendications précédentes, lequel présente au moins un prolongement de fixation en position (23) qui est réalisé pour coopérer avec la carte de circuits imprimés (5) de manière que l'élément de retenue (1) soit fixé dans sa position par rapport à la carte de circuits imprimés (5) au moins dans deux des trois directions de l'espace.

7. Elément de retenue selon l'une des revendications précédentes, lequel est réalisé au moins en partie en tôle, la formation de fixation (11) et/ou le prolongement d'arrêt (17) et/ou le prolongement de fixation en position (23) étant réalisés en particulier par matriçage et coudage de cette tôle.

8. Elément de retenue selon l'une des revendications précédentes, lequel est relié à un mini- ou microventilateur (3).
